(19) Europäisches Patentamt / European Patent Office / Office européen des brevets

(11) **EP 2 211 469 A1**

(12) **EUROPEAN PATENT APPLICATION**

(43) Date of publication:
    **28.07.2010 Bulletin 2010/30**

(51) Int Cl.:
    **H03M 13/00** $^{(2006.01)}$

(21) Application number: **09100063.8**

(22) Date of filing: **23.01.2009**

(84) Designated Contracting States:
    **AT BE BG CH CY CZ DE DK EE ES FI FR GB GR HR HU IE IS IT LI LT LU LV MC MK MT NL NO PL PT RO SE SI SK TR**
    Designated Extension States:
    **AL BA RS**

(71) Applicant: **Nokia Siemens Networks Oy**
    **02610 Espoo (FI)**

(72) Inventor: **Cannalire, Giacomo Francesco**
    **20062, Cassano d'Adda (IT)**

(74) Representative: **Fischer, Michael**
    **Nokia Siemens Networks GmbH & Co. KG**
    **COO RTP IPR, Patent Administration**
    **80240 München (DE)**

(54) **Method of encoding or decoding for LDPC codes**

(57)    A method and system for encoding or decoding for LDPC codes in which exponent matrixes are converted, said LDPC codes being implemented with semi-random technique which requires that the exponent matrix is composed of three sub-matrixes, a random sub-matrix, a semi-deterministic column vector and a deterministic sub-matrix, the invention comprising:

c) providing a base-model exponent sub-matrix of size $r_b x(k_b+1)$ constituting the random sub-matrix and the semi-deterministic column vector of a base model exponent matrix having maximum codeword-length $n_0$ and maximum spreading factor $Z_0$;

d) from said base-model exponent sub-matrix, obtaining a converted exponent sub-matrix of size $r_b x(k_b+1)$ constituting the random sub-matrix and the semi-deterministic column vector of a converted exponent matrix having desired codeword length $n<n_0$ and desired spreading factor $Z_f<Z_0$; wherein each element $(i,j)$ of said converted exponent sub-matrix is obtained by an opportune translation of the corresponding $(i,j)$ element of said base model exponent matrix; wherein item b) comprises the following:

- each element $(i,j)$ of the base model exponent sub-matrix with value smaller than $Z_f$ is translated, into the corresponding converted exponent sub-matrix element $(i,j)$, without any processing;

- each element $(i,j)$ of the base model exponent sub-matrix with value comprised between $Z_f$ and $Z_0$ is translated, into the corresponding converted exponent sub-matrix element $(i,j)$, via a processing so as to obtain an integer number with value comprised between $0$ and $(Z_f-1)$.

| r\c | 1 | 2 | 3 | 4 | 5 | 6 | 7 | 8 | 9 | 10 | 11 | 12 | 13 | i | 80 | 81 | 82 | 83 | 84 | 85 | 86 | 87 | 88 | 89 | 90 | 91 |
|---|---|---|---|---|---|---|---|---|---|---|---|---|---|---|---|---|---|---|---|---|---|---|---|---|---|---|
| 1 | 36 | 42 | 48 | 54 | 60 | 66 | 72 | 78 | 84 | 90 | 96 | 102 | 0 | | 74 | 80 | 86 | 92 | 98 | 104 | 1 | 7 | 13 | 19 | 25 | 31 |
| 2 | 40 | 50 | 60 | 70 | 80 | 90 | 100 | 1 | 11 | 21 | 31 | 41 | 51 | | 67 | 77 | 87 | 97 | 107 | 8 | 18 | 28 | 38 | 48 | 58 | 68 |
| 3 | 94 | 99 | 104 | 1 | 6 | 11 | 16 | 21 | 26 | 31 | 36 | 41 | 46 | | 54 | 59 | 63 | 68 | 73 | 78 | 83 | 88 | 93 | 98 | 103 | 0 |
| 4 | 13 | 24 | 35 | 46 | 57 | 68 | 79 | 89 | 100 | 3 | 14 | 25 | 36 | | 10 | 21 | 32 | 43 | 54 | 65 | 76 | 86 | 97 | 0 | 11 | 22 |
| 5 | 34 | 38 | 42 | 46 | 50 | 54 | 58 | 62 | 66 | 70 | 74 | 78 | 82 | | 23 | 27 | 31 | 35 | 39 | 43 | 47 | 51 | 55 | 59 | 63 | 67 |
| 6 | 87 | 90 | 93 | 96 | 99 | 102 | 105 | 0 | 3 | 6 | 9 | 12 | 15 | | 106 | 1 | 4 | 7 | 10 | 13 | 16 | 19 | 22 | 25 | 28 | 31 |

**Fig.2**

**Description**

The present invention relates to a method and to a system according the preambles of claims 1,2 and 6.

### Backgroud Art

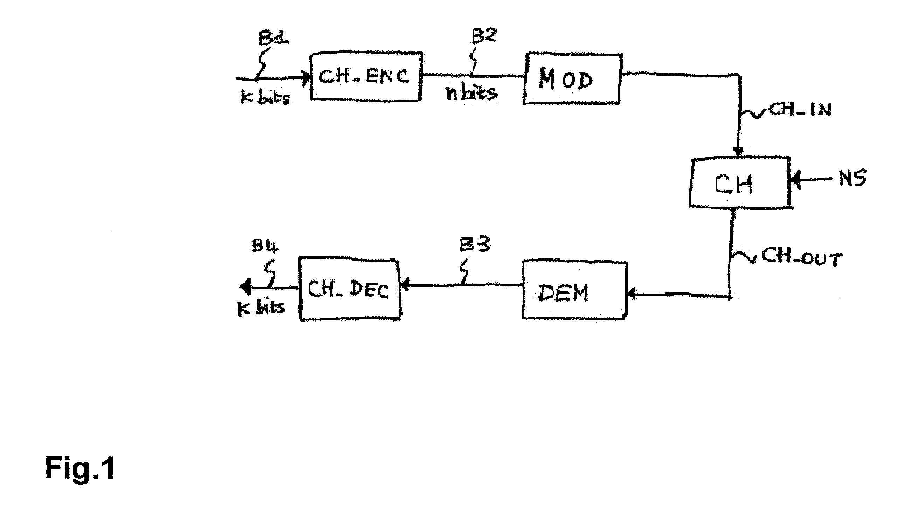

Let us consider a schematic example of a digital communication system model as the one shown in the block diagram of Figure 1.

The input of channel encoder CH_ENC is an information sequence B1 of $k$ bits to which a redundancy sequence of $r$ bits is added thereby producing an encoded sequence B2 of $n$ bits.

The channel code rate $R$ is defined as the ratio between the information bits number $k$ and the encoded bits number $n$, thus $R = k / n$ .

Modulator MOD transforms the encoded vector B2 into a modulated signal vector CH_IN which is in turn transmitted through a channel CH. Since the channel CH is usually subject to noisy disturbance NS, the channel output CH_OUT may differ from the channel input CH_IN.

At the receiving end, the channel output CH_OUT is processed by the demodulator DEM which performs the inverse operation of the modulator MOD and produces some likelihood ratio.

The channel decoder CH_DEC uses the redundancy in the received sequence B3 to correct the error in the information sequence of the received sequence B3 and produces a decoded signal B4 which is an information signal estimate.

State of the art encoder/decoder structures CH_ENC, CH_DEC use codes Low Density Parity Check (LDPC) code as proposed by the IEEE 802.16e Standard for Air Interface For Fixed and Mobile Broadband Wireless Access Systems [Ref.1].

LDPC codes are block codes. Block codes use a generator matrix $G$ for the encoding operation and a parity-check matrix $H$ for the decoding operation.

For a block code with information sequence of $k$ bits, a codeword of $n$ bits and redundancy (parity) sequence of $r=(n-k)$ bits, the generator matrix $G$ has $kxn$ dimensions, and the parity-check matrix $H$ has $rxn=(n-k)xn$ dimensions.

These two matrixes enjoy the orthogonal property, which states that for any matrix $G_{kxn}$ with $k$ linearly independent rows there exists a matrix $H_{rxn}$ with $r=(n-k)$ linearly independent rows such that any row of $G_{kxn}$ is orthogonal to the rows of $H_{rxn}$ such that the following equation is satisfied:

$$(i)\ G_{kxn}\ .\ H^{T}_{rxn}=0$$

The encoding operation is performed by means of the multiplication between the information sequence $U_{1xk}$ and the code generator matrix $G_{kxn}$. The result, of such multiplication, is the encoded output sequence $V_{1xn}$ as follows:

$$(ii)\qquad V_{1xn} = U_{1xk} \cdot G_{kxn}$$

At the receiving side, due to the orthogonal property between matrixes $G_{kxn}$ and $H_{rxn}$, the following equation should be satisfied:

$$(iii)\qquad H_{rxn} \cdot B^{T}_{nx1} = 0$$

where $B^{T}_{nx1}$ is the decoded received sequence which comprises the information signal estimate B4. If equation *(iii)* is verified the information signal estimate B4 is correct otherwise the errors in the received sequence B3 exceed the correction capacity of the carried-out code.

Once the code generator matrix $G_{kxn}$ is built, it is possible to obtain the parity-check matrix $H_{rxn}$ and vice versa. The proposed invention relates to both "channel encoder" and "channel decoder" of Figure 1 for LDPC codes.

There are several design techniques for generating the parity-check matrix $H_{rxn}$ of a LDPC code. The most used generating technique in LDPC code design is the semi-random technique.

The parity-check matrix $H_{rxn}$ is built combining in a certain manner three matrixes: the exponent matrix $H^{exp}$

for a specific rate R, the seed matrix for the rate $R$ and the spreading matrix for a given spreading factor $Z_f$. The element-by-element multiplication of the non-binary exponent matrix $H^{exp}$ with the seed matrix generates another exponent matrix $E^{exp}$, herein-after denoted as "masked" exponent matrix, which is in turn expanded to the parity-check matrix $H_{rxn}$, hereby also called expanded matrix $H_{rxn}$, via the spreading matrix. The spreading matrix is a square binary matrix of weight one and dimension $Z_f x Z_f$, being $Z_f$ the desired spreading factor which is tied to the codeword length of the carried-out LDPC code.

An exponent matrix is a conventional matrix representing a block structured matrix. The elements of the exponent matrix are expanded in square matrixes of dimension $Z_f x Z_f$ by applying the rules known from the art. According to such known rules, the elements of the exponent matrix $H^{exp}$ represent permutation matrixes of the identity matrix, with weight equal to "1" for each row and for each column, with dimensions $Z_f x Z_f$. The value of the exponent matrix element indicates the cyclic shift to the right of the identity matrix. Hence, the term "exponent matrix" is an expression widely used in the art to conventionally denote a matrix whose elements, also called "exponents", represent permutation matrixes of the identity matrix with the given exponent. It is noted that, in the art, the term "exponent" used for the elements of the exponent matrix may sometimes be replaced with the equivalent term "shift-size".

The same "expansion" rules apply to the masked exponent matrix $E^{exp}$ obtained by multiplicating, element-by-element, the exponent matrix $H^{exp}$, with the seed matrix. Hence, the expanded matrix $H_{rxn}$ is obtained by the above outlined expansion of the exponent matrix $E^{exp}$.

As used herein, the term exponent matrix may refer, depending on the context, either to the exponent matrix $H^{exp}$ or to the masked exponent matrix $E^{exp}$ which is specific to the code-rate $R$ or to both matrixes by using the more generic notation "$K^{exp}$".

When realized with semi-random technique, the expanded matrix $H_{rxn}$ is constituted of two sub-matrixes: the first sub-matrix is a random matrix having $(n-k)xk = rxk$ size and the second one is a semi-deterministic sub-matrix of $(n-k)x(n-k) = rxr$ size. The exponent matrix $H_{exp}$ is used in the implementation of both LDPC encoder and LDPC decoder. In the LDPC encoding operation, Method 2 , shown in standard IEEE 802.16e [Ref.1], allows to reduce the LDPC encoder hardware complexity if the exponent matrix $H_{exp}$ is split in opportune sub-matrixes, a random one and a semi-deterministic one: the semi-determininistic sub-matrix is itself split into a semi-deterministic column vector $Cv$, its first column vector which is constructed in an opportune way, and a deterministic matrix which is typically a bi-diagonal matrix as known from the art.

### *Technical Problem*

In digital communication systems, it is sometimes required to change the communication system configurations, e.g. in case of changes of transmission requirements or in case of changes of channel transmission quality. For example when there is an increased amount of errors at the receiving part, because of a transmission channel worsening, e.g. in case of rain benches or in presence of new obstacles, it is necessary to modify the communication system configuration by changing or the modulation type or the channel coding or both in order to reduce the bit-rate and thus improving the system performances.

Hence, a change in the LDPC codeword length $n$ may be required with the aim of operating a transition to LDPC codeword lengths having a different degree of robustness.

As used herein, the terminology "base-model" parity-check exponent matrix refers to the parity-check exponent matrix built for the maximum codeword length no, having thus the maximum spreading factor $Z_0$.

Advantageously, as known from the art, such base model exponent matrix can be used to derive, via some conversion formulas, other exponent matrix having other desired codeword lengths $n < n_0$, and thus spreading factors $Z_f < Z_0$. In other words, the elements in the base model matrix can be used to determine, via some conversion formulas, the desired exponent matrixes for other desired code lengths n < no with desired spreading factor $Z_f < Z_0$.

Advantageously, the required storage place in the hardware device is reduced since it is possible to store only the base model exponent matrix built for the maximum codeword length $n_0$ and to subsequently derive, via such conversion formulas, other exponent matrixes for shorter codeword lengths $n < n_0$.

According to IEEE 802.16e Standard [Ref.1], the conversion from the base model exponent matrix (maximum spreading factor $Z_0$) to the desired converted exponent matrix, with desired spreading factor $Z_f < Z_0$, is carried-out with the formula reported in IEEE 802.16e Standard [Ref.1] on page 627, relation (129a) to be applied to the random part and the semi-deterministic column vector of the exponent matrix.

The IEEE 802.16e Standard [Ref.1] conversion formula is the following:

$$(i) \qquad K_{i,j}^{\exp} = \begin{cases} K_{i,j}^{\exp} & for \quad K_{i,j}^{\exp} \le 0 \\ floor(K_{i,j}^{\exp} \cdot \dfrac{Z_f}{Z_0}) & for \quad K_{i,j}^{\exp} > 0 \end{cases}$$

where $K_{i,j}^{\exp}$ denotes the value of the generic matrix element *(i,j)* of the exponent matrix $K^{\exp}$ and the *"floor function"* gives the nearest integer towards "-∞" ".

*F*or each element bigger than zero a proportionally scaling operation is performed; the scaling factor being $Z_f$ / $Z_0$ in order to implement the desired LDPC codeword length *n*. In addition, after the scaling operation, a "floor function" operation is performed in order to obtain the integer values.

As shown in the above formula of equation *(i)*, the only base matrix elements translated into the converted matrix elements without any processing are the elements having value smaller or equal to "*0*".

It is noted that, according to the known art, the preferred base model exponent matrixes $H^{\exp}$, also used for building the masked exponent matrixes $E^{\exp}$ as indicated in the IEEE 802.16e Standard [Ref.1], are built so that in each of their rows are present all elements having value comprised between *0* and ($Z_0$ -1) in order to minimize the number of overlaps bigger than 1.

Unfortunately, such way of constructing the base model exponent matrix $H^{\exp}$ coupled with the conversion formula of equation *(i)* have the drawback that, during the conversion, only a low number of base model matrix elements are translated without any processing.

This has a negative impact on the required computational efforts and on the required transition time for operating a change of the LDPC codeword length.

For the above mentioned base model matrix, the number of elements which do not require processing in the conversion method known from the IEEE 802.16e Standard [Ref.1] can be estimated as being circa equal to:

$$(ii) \qquad ceil\big[(k_b + 1)/Z_f\big]$$

where $k_b$ is the block structured information sequence length and where the *"ceil"* function returns the nearest integer towards "+∞".

Let us apply the formula of equation *(ii)* in a numerical example to estimate the number of non-processed elements of an exemplary base model exponent matrix $H^{\exp}$.

Let us consider as exemplary base model exponent matrix, an exponent matrix $H_{6x96}^{\exp}$ of an LDPC code with block structured information sequence $k_b$ = 90, block codeword length $n_b$ = 96 , block parity sequence = $n_b$ - $k_b$ = 6 and code-rate $R = k_b / n_b = (n_b - r_b ) / n_b$ = 15/16.

The number of non-processed elements is computed for the conversion of the base model matrix into three desired converted exponent matrixes, having the three following spreading factors $Z_f = \dfrac{1}{4}Z_0$, $Z_f = \dfrac{1}{2}Z_0$ and $Z_f = \dfrac{8}{9}Z_0$.

A) for $Z_f = \dfrac{1}{4}Z_0 \qquad \Rightarrow \qquad ceil\big[(k_b + 1)/Z_f\big] = 4\_elements\_for\_row$ Thus, for $Z_f = \dfrac{1}{4}Z_0$,

out of $r_b x(k_b + 1) = 6x91 = 546$ elements (i.e. the number of elements of the random exponent sub-matrix and of the semi-deterministic column vector), circa (6*x*4)=24 elements are not processed.

B) for $Z_f = \dfrac{1}{2}Z_0 \qquad \Rightarrow \qquad ceil\big[(k_b + 1)/Z_f\big] = 2\_elements\_for\_row$ Thus, for $Z_f = \dfrac{1}{2}Z_0$,

out of 546 elements, circa (6$x$2)=12 elements are not processed

$$C) \quad for \quad Z_f = \frac{8}{9}Z_0 \quad \Rightarrow \quad ceil\big[(k_b+1)/Z_f\big]=1\_elements\_for\_row \quad \text{Thus,} \quad \text{for}$$

$$Z_f = \frac{8}{9}Z_0 \text{, then out of 546 elements, circa (6$x$1)=6 elements are not processed}$$

As seen above, the known method for converting exponent matrixes for LDPC codes has the drawback of requiring processing on most of elements of the base model exponent matrix, thus impacting the required computational efforts involved in operating a transition to a different codeword length.

It is therefore aim of the present invention to reduce the computational efforts required in operating a codeword length change, by providing a method and a system for encoding or decoding LDPC codes, in which exponent matrixes are converted, which reduces the number of arithmetic operations required for converting the base model exponent matrix for the largest LDPC codeword length no to the converted exponent matrixes with a desired codeword length $n < n_0$.

The above mentioned aim is achieved by method and system for encoding or decoding for LDPC codes in which exponent matrixes are converted, the LDPC codes being implemented with semi-random technique which requires that the exponent matrix is composed of three sub-matrixes, a random sub-matrix, a semi-deterministic column vector and a deterministic sub-matrix, the invention comprising:

a) providing a base-model exponent sub-matrix of size $r_b x(k_b+1)$ constituting the random sub-matrix and the semi-deterministic column vector of a base model exponent matrix having maximum codeword-length $n_0$ and maximum spreading factor $Z_0$;

b) from said base-model exponent sub-matrix, obtaining a converted exponent sub-matrix of size $r_b x(k_b+1)$ constituting the random sub-matrix and the semi-deterministic column vector of a converted exponent matrix having desired codeword length $n<n_0$ and desired spreading factor $Z_f<Z_0$; wherein each element ($i,j$) of said converted exponent sub-matrix is obtained by an opportune translation of the corresponding ($i,j$) element of said base model exponent matrix; wherein item b) comprises the following:

- each element ($i,j$) of the base model exponent sub-matrix with value smaller than $Z_f$ is translated, into the corresponding converted exponent sub-matrix element ($i,j$), without any processing;
- each element ($i,j$) of the base model exponent sub-matrix with value comprised between $Z_f$ and $Z_0$ is translated, into the corresponding converted exponent sub-matrix element ($i,j$), via a processing so as to obtain an integer number with value comprised between $0$ and $(Z_f-1)$.

In embodiments of the proposed invention, the performed translations in item b) may conveniently be expressed via the below equation:

$$K_{i,j}^{exp} = \begin{cases} K_{i,j}^{exp} & for \quad K_{i,j}^{exp} < Z_f \\ \mathrm{mod}(\mathrm{mod}(K_{i,j}^{exp}, p_f), Z_f) & for \quad K_{i,j}^{exp} \geq Z_f \end{cases} \qquad (1)$$

where $K_{i,j}^{exp}$ denotes the value of the exponent sub-matrix generic element ($i,j$) and where $p_f$ is the first prime number bigger than $Z_f$.

In embodiments of the proposed invention, the base-model exponent sub-matrix of item a) may preferably be a masked exponent sub-matrix constituting the random sub-matrix and the semi-deterministic column vector of a masked base model exponent matrix $E^{exp}$.

With the proposed invention, only a reduced number of elements of the base model exponent matrix require processing when implementing LDPC codes with shorter codeword lengths $n < n_0$. Instead, as known from the IEEE 802.16e Standard [Ref.1], the majority of the elements of the base model exponent matrix are processed during the conversion for operating a codeword length change.

Advantageously, the proposed invention achieves a reduction of the required arithmetical operations and a reduction of the required transition time for changing the LDPC codeword length.

Moreover, embodiments of the invention do not require, differently from the conversion formula *(i)* of the IEEE 802.16e Standard [Ref.1], the costly task of storing in the memory the ratio $Z_f/Z_0$ and of using such ratio to multiply all elements of the base model exponent matrix which have value greater than zero.

The invention will now be described in preferred but not exclusive embodiments with reference to the accompanying drawings, wherein:

Figure 1    is block diagram, already described, schematically illustrating a digital communication system model (Prior Art);

Figure 2    is a matrix showing an exemplary base model exponent sub-matrix;

Figure 3    is a matrix showing an exemplary converted exponent sub-matrix obtained from the sub-matrix of Figure 2.

According to the proposed method for encoding or decoding LDPC codes, a base model exponent matrix $K^{exp}$ with maximum codeword-length $n_0$ and maximum spreading factor $Z_0$ is converted to a converted exponent matrix by performing a set of conversion operations. Such conversion operations may be applied either to the base model exponent matrix $H^{exp}$ or, preferably, to the base model masked $E^{exp}$ so as to further reduce the required number of arithmetic conversion operations.

The conversion operations are performed on the random sub-matrix and on the semi-deterministic column vector of the base model exponent matrix $K^{exp}$, given the fact that the deterministic exponent sub-matrix may be built as known in the art with elements having value not greater than zero.

Hence, the conversion operations are applied to a base-model exponent sub-matrix of size $r_b \times (k_b+1)$ constituting the random sub-matrix and the semi-deterministic column vector of a base model exponent matrix having maximum codeword-length $n_0$ and maximum spreading factor $Z_0$.

The resulting converted exponent sub-matrix, obtained from the conversion, has also size $r_b \times (k_b+1)$ and it is the random sub-matrix and the semi-deterministic column vector of the desired converted exponent matrix having desired codeword length $n < n_0$ and desired spreading factor $Z_f < Z_0$.

In the resulting converted exponent sub-matrix, each element *(i,j)* is obtained by an opportune translation of the corresponding *(i,j)* element of the base model exponent sub-matrix as follows:

- each element *(i,j)* of the base model exponent sub-matrix with value smaller than $Z_f$ is translated into the corresponding converted exponent sub-matrix element *(i,j),* without any processing;
- each element *(i,j)* of the base model exponent sub-matrix with value comprised between $Z_f$ and $Z_0$ is translated, into the corresponding converted exponent sub-matrix element *(i,j),* via a processing so as to obtain an integer number with value comprised between between *0* and *($Z_f$-1)*.

In a preferred embodiment of the proposed invention, the translation formula expressing the conversion steps from the base model exponent matrix $K^{exp}$ with maximum spreading factor $Z_0$ - corresponding to the maximum LDPC codeword length no - into the exponent matrix with spreading factor $Z_f < Z_0$ - corresponding to shorter LDPC codeword lengths n < no may be given by equation (1) below:

$$(1) \qquad K_{i,j}^{exp} = \begin{cases} K_{i,j}^{exp} & for \quad K_{i,j}^{exp} < Z_f \\ \\ \mathrm{mod}(\mathrm{mod}(K_{i,j}^{exp}, p_f), Z_f) & for \quad K_{i,j}^{exp} \geq Z_f \end{cases}$$

where $K_{i,j}^{exp}$ denotes the value of the exponent sub-matrix generic element *(i,j)* and where $p_f$ is the first prime number bigger than $Z_f$. The definition of operator *mod(x,y)* is well known from the art.

In the conversion formula of equation (1) there are two "mod" operations.

The first "mod" operation, the inner one, applied to the base model matrix elements having value $K_{i,j}^{exp}$ com-

prised between $Z_f \leq K_{i,j}^{\exp} < Z_0$, modifies only the elements of the base model exponent matrix elements having

value $K_{i,j}^{\exp}$ comprised between $p_f \leq K_{i,j}^{\exp} < Z_0$.

The second "mod" operation, the outer one, applied to the elements resulting from the first "mod" operation, modifies only the base model matrix elements having value $K_{i,j}^{\exp}$ comprised between $Z_f \leq K_{i,j}^{\exp} < p_f$

The conversion formula of equation (1) may be applied when converting the base model exponent matrix $H^{\exp}$ recommended in the known art and the masked $E^{\exp}$ one indicated in the Standard IEEE 802.16e [1]. As above explained, such base model exponent matrix $H^{\exp}$ - as recommended in the known art - is built to have, in each row, all elements, having value comprised between $0$ and $(Z_0 -1)$ , in order to minimize the number of overlaps bigger than 1.

Thus, the number of the elements of the base model matrix $H^{\exp}$ that are processed, within the random exponent matrix and the semi-deterministic column vector, when applying the conversion formula of equation (1) to the above mentioned base model exponent matrix, is estimated of being circa equal to:

$$(2) \qquad floor\left\{\left[(1-\frac{p_f}{Z_0})\cdot(2-\frac{Z_f}{p_f})\right]\cdot r_b \cdot (k_b +1)\right\}$$

where and $n_b$ are respectively the numbers of rows and of columns of the block structured exponent matrix and $k_b$ is the column number of the random part; being the LDPC code rate $R = k_b / n_b = (n_b - r_b) / n_b$.

The formula of equation (2) is applicable to the random and the semi-deterministic column vector of a base model exponent matrix $H^{\exp}$ not masked by the rate-specific seed matrix. In case it is desired to estimate the number of elements that are processed for masked sub-matrixes $E^{\exp}$, as for example the masked exponent sub-matrixes indicated in the IEEE 802.16e Standard [Ref.1], then, from the results of the equation (2), it is necessary to subtract the number of the elements having value "-1" in the masked exponent sub-matrix.

Advantageously, the converted exponent matrix with spreading factor , $Z_f$ obtained with embodiments of the proposed invention, proves to be closer to the exponent matrix with spreading factor $Z_f$ computed directly - without any conversion - than the converted exponent matrix with spreading factor $Z_f$ obtained with the conversion formula *(i)* of the IEEE 802.16e Standard [Ref.1].

In fact, according to the formula of equation (1), only the base model matrix elements bigger or equal than $Z_f$ (enough close to the direct construction of the exponent matrix with spreading $Z_f$) are processed and opportunely decreased in value, while, according to formula *(i)* of the IEEE 802.16e Standard [Ref.1], all base model matrix elements, except the zero exponent, are processed via a proportionally scaling that compresses all the elements having value comprised between 0 and $(Z_0 - 1)$ into elements having value comprised between 0 and $(Z_f- 1)$. In the formula of equation (1), the use of the prime number $p_f$ allows to have in each row of the converted exponent matrix elements having all value comprised between $0$ and $(Z_f- 1)$, thus advantageously minimizing the number of overlaps bigger than "*1*".

***Numerical example with conversion formula of equation (1)***

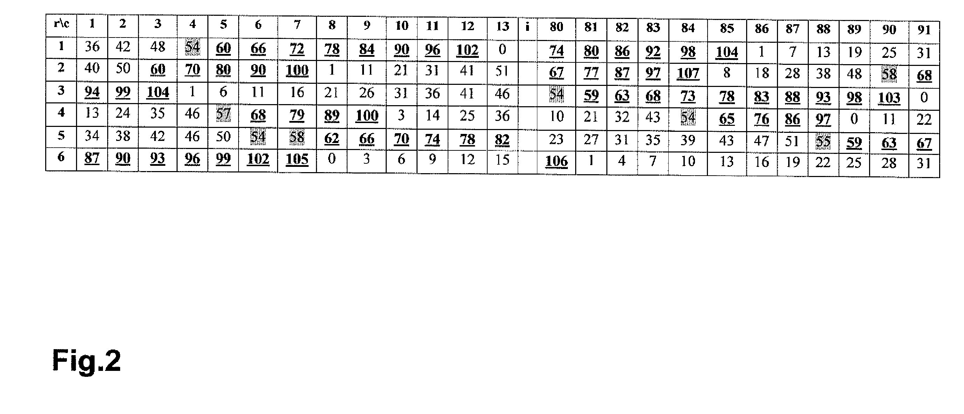

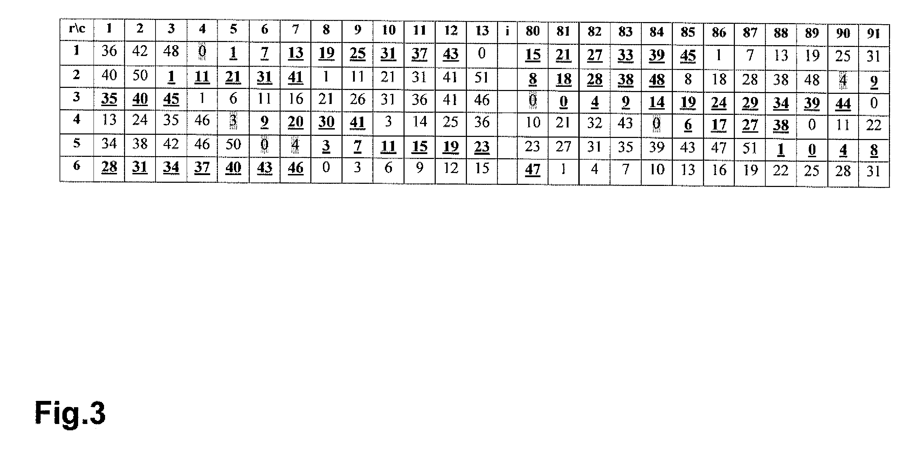

A numerical example, according to an embodiment of the present invention, is illustrated in which the conversion formula of equation (1) is implemented as illustrated in the sub-matrixes of Figures 2 and 3.

Let us consider an LDPC code, with rate $R$ = 15/16, having as largest information sequence $k_0$ = 9720 and as highest spreading factor $Z_0$ =108 . The parameters no, $n_b$, $k_b$ and $r_b$ are then computed as follows:

- The largest LDPC codeword length $n_0$ is computed as $n_0 = k_0 / R$ = 10368
- The column number $n_b$ of the block structured base model exponent matrix $H^{\exp}$ is computed as $n_b = n_0 / Z_0$ = 96
- The block structured information sequence $k_b$ is computed as $k_b = k_0 / Z_0$ = 90
- The row number $r_b$ is computed as $r_b = n_b - k_b$ = 6

The base model exponent matrix is built, as known from the art, with semi-random technique, with random sub-matrix having size $r_b x k_b$, with the semi-deterministic column vector having size $r_b x 1$ and with the deterministic sub-matrix having size $r_b x (r_b-1)$.

Figure 2 shows the base model exponent sub-matrix having size *6x91,* built as recommended in the known art, constituting the random sub-matrix and the semi-deterministic column vector of the base model exponent matrix $H_{6x96}^{\exp}$, built for the largest LDPC code length $n_0$ = 10368 with $Z_0$ =108 and $R$ = 15/16.

Let us derive, from the base model exponent sub-matrix of Figure 2, the converted exponent sub-matrix of Figure 3 with rate $R$ = 15/16, with codeword length $n=5184$ (being $Z_f=54$ and $p_f=59$) by applying the conversion formula of equation (1).

The base model matrix elements with value $H_{i,j}^{\exp} < Z_f=54$ are not processed.

The inner "mod" of equation (1), applied to the base model matrix elements having value $H_{i,j}^{\exp}$ comprised between $54 \leq H_{i,j}^{\exp} < 108$, modifies only the elements of the base model exponent matrix elements having value $H_{i,j}^{\exp}$ comprised between $59 \leq H_{i,j}^{\exp} < 108$ as highlighted with bold and underlined format in the sub-matrixes of Figures 2 and 3.

The outer "mod" operation of Figure 2 applied to the elements resulting from the first "mod" operation, modifies only the base model matrix elements having value $H_{i,j}^{\exp}$ comprised between $54 \leq H_{i,j}^{\exp} < 59$ as highlighted with shaded format in the sub-matrixes of Figures 2 and 3.

### Numerical Example: estimating the number of non processed elements

A simple numerical example, aiming at quantifying the benefits provided by an embodiment of the present invention, is illustrated.

The formula of equation (2) is applied in a numerical example to compute an estimate of the number of non-processed elements for an exemplary base model exponent matrix $H_{6x96}^{\exp}$.

Let us consider an exponent matrix $H_{6x96}^{\exp}$ of an LDPC code with block structured information sequence $k_b$ = 90 , block codeword length $n_b$ = 96 , block parity sequence $r_b = n_b - k_b = 6$ and rate $R = k_b / n_b = (n_b - r_b) / n_b$ = 15/16.

Let us compute an estimate of the number of non-processed elements for the four following spreading factors

$$Z_f = \frac{1}{4}Z_0, \quad Z_f = \frac{1}{2}Z_0, \quad Z_f = \frac{3}{4}Z_0 \text{ and } Z_f = \frac{8}{9}Z_0.$$

A) for $Z_f = \frac{1}{4}Z_0$ and $Z_0$ =108 , it is then $Z_f$ = 27 and $p_f$ = 29 Since equation (4) returns:

$$floor\left\{\left[(1-\frac{29}{108}) \cdot (2-\frac{27}{29})\right] \cdot 6 \cdot 91\right\} = 426,$$ then out of $r_b x(k_b + 1)$ = 6x91 = 546 elements, circa 546-426=120 elements are not processed.

B) for $Z_f = \frac{1}{2}Z_0$ and $Z_0$ =108 , it is then $Z_f$ and $p_f$ = 59 Since equation (4) returns:

$$floor\left\{\left[(1-\frac{59}{108}) \cdot (2-\frac{54}{59})\right] \cdot 6 \cdot 91\right\} = 268,$$ then out of 6x91=546 elements, circa 546-268=278 elements are not processed.

C) for $Z_f = \frac{3}{4}Z_0$ and $Z_0$ = 108, it is then $Z_f$ = 81 and $p_f$ = 83 Since equation (4) returns:

$$floor\left\{\left[(1-\frac{83}{108})\cdot(2-\frac{81}{83})\right]\cdot 6\cdot 91\right\}=129,$$ then out of *6x91=546* elements, circa *546-129=417* elements are not processed.

D) for $Z_f = \frac{8}{9}Z_0$ and $Z_0$ = 108, it is then $Z_f$ = 96 and $p_f$ = 97 Since equation (4) returns:

$$floor\left\{\left[(1-\frac{97}{108})\cdot(2-\frac{96}{97})\right]\cdot 6\cdot 91\right\}=56$$ then out of *6x91=546* elements, circa *546-56=490* elements are not processed.

As it is shown in the above example, with embodiments of the proposed invention, in order to implement LDPC codes with codeword lengths $n < n_0$, the number of elements to be processed, in the base model exponent matrix recommended in the art, decreases with the increase of the spreading factor $Z_f$ to a point in which the number of non processed elements exceeds the number of processed elements of the exponent sub-matrix.

*References*

[Ref.1] IEEE Std 802.16e - Air Interface for Fixed and Mobile Broadband Wireless Access Systems - 28 February 2006

**Claims**

1.  A method of encoding for LDPC codes in which exponent matrixes are converted, said LDPC codes being implemented with semi-random technique which requires that the exponent matrix is composed of three sub-matrixes, a random sub-matrix, a semi-deterministic column vector and a deterministic sub-matrix,
    the method comprising the steps of:

    a) providing a base-model exponent sub-matrix of size $r_b x(k_b+1)$ constituting the random sub-matrix and the semi-deterministic column vector of a base model exponent matrix having maximum codeword-length no and maximum spreading factor $Z_0$;
    b) from said base-model exponent sub-matrix, obtaining a converted exponent sub-matrix of size $r_{bx}(k_b+1)$ constituting the random sub-matrix and the semi-deterministic column vector of a converted exponent matrix having desired codeword length $n<n_0$ and desired spreading factor $Z_f<Z_0$; wherein each element (*i,j*) of said converted exponent sub-matrix is obtained by an opportune translation of the corresponding (*i,j*) element of said base model exponent matrix;

    the method being **characterized in that** step b) comprises the following sub-steps:

    - each element (*i,j*) of the base model exponent sub-matrix with value smaller than $Z_f$ is translated, into the corresponding converted exponent sub-matrix element (*i,j*), without any processing;
    - each element *(i,j)* of the base model exponent sub-matrix with value comprised between $Z_f$ and $Z_0$ is translated, into the corresponding converted exponent sub-matrix element (*i,j*), via a processing so as to obtain an integer number with value comprised between 0 and *($Z_f$-1)*.

2.  A method of decoding for LDPC codes in which exponent matrixes are converted, said LDPC codes being implemented with semi-random technique which requires that the exponent matrix is composed of three sub-matrixes, a random sub-matrix, a semi-deterministic column vector and a deterministic sub-matrix, the method comprising the steps of:

    a) providing a base-model exponent sub-matrix of size $r_b x(k_b+1)$ constituting the random sub-matrix and the semi-deterministic column vector of a base model exponent matrix having maximum codeword-length $n_0$ and maximum spreading factor $Z_0$;

b) from said base-model exponent sub-matrix, obtaining a converted exponent sub-matrix of size $r_b \times (k_b + 1)$ constituting the random sub-matrix and the semi-deterministic column vector of a converted exponent matrix having desired codeword length $n < n_0$ and desired spreading factor $Z_f < Z_0$; wherein each element $(i,j)$ of said converted exponent sub-matrix is obtained by an opportune translation of the corresponding $(i,j)$ element of said base model exponent matrix;

the method being **characterized in that** step b) comprises the following sub-steps:

- each element $(i,j)$ of the base model exponent sub-matrix with value smaller than $Z_f$ is translated, into the corresponding converted exponent sub-matrix element $(i,j)$, without any processing;
- each element $(i,j)$ of the base model exponent sub-matrix with value comprised between $Z_f$ and $Z_0$ is translated, into the corresponding converted exponent sub-matrix element $(i,j)$, via a processing so as to obtain an integer number with value comprised between 0 and $(Z_f - 1)$.

3. The method according to any of the preceding claims, wherein the translations performed in the sub-steps of step b) are expressed via the below equation:

$$K_{i,j}^{\exp} = \begin{cases} K_{i,j}^{\exp} & \text{for} \quad K_{i,j}^{\exp} < Z_f \\ \\ \mathrm{mod}(\mathrm{mod}(K_{i,j}^{\exp}, p_f), Z_f) & \text{for} \quad K_{i,j}^{\exp} \geq Z_f \end{cases}$$

where $K_{i,j}^{\exp}$ denotes the value of the exponent sub-matrix generic element $(i,j)$ and where $p_f$ is the first prime number bigger than $Z_f$.

4. The method according to any of the preceding claims, wherein the base-model exponent sub-matrix of step a) is a masked exponent sub-matrix constituting the random sub-matrix and the semi-deterministic column vector of a masked base model exponent matrix $E^{\exp}$.

5. A method of data transmission comprising the steps of the method according to any of the preceding claims.

6. A system having means for performing the steps of the method according to any of the preceding claims.

**Fig.1**

EP 2 211 469 A1

| r\c | 1 | 2 | 3 | 4 | 5 | 6 | 7 | 8 | 9 | 10 | 11 | 12 | 13 | i | 80 | 81 | 82 | 83 | 84 | 85 | 86 | 87 | 88 | 89 | 90 | 91 |
|---|---|---|---|---|---|---|---|---|---|---|---|---|---|---|---|---|---|---|---|---|---|---|---|---|---|---|
| 1 | 36 | 42 | 48 | 54 | 60 | 66 | 72 | 78 | 84 | 90 | 96 | 102 | 0 | | 74 | 80 | 86 | 92 | 98 | 104 | 1 | 7 | 13 | 19 | 25 | 31 |
| 2 | 40 | 50 | 60 | 70 | 80 | 90 | 100 | 1 | 11 | 21 | 31 | 41 | 51 | | 67 | 77 | 87 | 97 | 107 | 8 | 18 | 28 | 38 | 48 | 58 | 68 |
| 3 | 94 | 99 | 104 | 1 | 6 | 11 | 16 | 21 | 26 | 31 | 36 | 41 | 46 | | 54 | 59 | 63 | 68 | 73 | 78 | 83 | 88 | 93 | 98 | 103 | 0 |
| 4 | 13 | 24 | 35 | 46 | 57 | 68 | 79 | 89 | 100 | 3 | 14 | 25 | 36 | | 10 | 21 | 32 | 43 | 54 | 65 | 76 | 86 | 97 | 0 | 11 | 22 |
| 5 | 34 | 38 | 42 | 46 | 50 | 54 | 58 | 62 | 66 | 70 | 74 | 78 | 82 | | 23 | 27 | 31 | 35 | 39 | 43 | 47 | 51 | 55 | 59 | 63 | 67 |
| 6 | 87 | 90 | 93 | 96 | 99 | 102 | 105 | 0 | 3 | 6 | 9 | 12 | 15 | | 106 | 1 | 4 | 7 | 10 | 13 | 16 | 19 | 22 | 25 | 28 | 31 |

**Fig.2**

EP 2 211 469 A1

| r\c | 1 | 2 | 3 | 4 | 5 | 6 | 7 | 8 | 9 | 10 | 11 | 12 | 13 | i | 80 | 81 | 82 | 83 | 84 | 85 | 86 | 87 | 88 | 89 | 90 | 91 |
|---|---|---|---|---|---|---|---|---|---|---|---|---|---|---|---|---|---|---|---|---|---|---|---|---|---|---|
| 1 | 36 | 42 | 48 | 0 | 1 | 7 | 13 | 19 | 25 | 31 | 37 | 43 | 0 | | 15 | 21 | 27 | 33 | 39 | 45 | 1 | 7 | 13 | 19 | 25 | 31 |
| 2 | 40 | 50 | 1 | 11 | 21 | 31 | 41 | 1 | 11 | 21 | 31 | 41 | 51 | | 8 | 18 | 28 | 38 | 48 | 8 | 18 | 28 | 38 | 48 | 4 | 9 |
| 3 | 35 | 40 | 45 | 1 | 6 | 11 | 16 | 21 | 26 | 31 | 36 | 41 | 46 | | 0 | 0 | 4 | 9 | 14 | 19 | 24 | 29 | 34 | 39 | 44 | 0 |
| 4 | 13 | 24 | 35 | 46 | 3 | 9 | 20 | 30 | 41 | 3 | 14 | 25 | 36 | | 10 | 21 | 32 | 43 | 0 | 6 | 17 | 27 | 38 | 0 | 11 | 22 |
| 5 | 34 | 38 | 42 | 46 | 50 | 0 | 4 | 3 | 7 | 11 | 15 | 19 | 23 | | 23 | 27 | 31 | 35 | 39 | 43 | 47 | 51 | 1 | 0 | 4 | 8 |
| 6 | 28 | 31 | 34 | 37 | 40 | 43 | 46 | 0 | 3 | 6 | 9 | 12 | 15 | | 47 | 1 | 4 | 7 | 10 | 13 | 16 | 19 | 22 | 25 | 28 | 31 |

# Fig.3

EP 2 211 469 A1

Europäisches
Patentamt

European
Patent Office

Office européen
des brevets

**PARTIAL EUROPEAN SEARCH REPORT**     Application Number

which under Rule 63 of the European Patent Convention EP 09 10 0063
shall be considered, for the purposes of subsequent
proceedings, as the European search report

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,A | IEEE: "IEEEStd 802.16e-2005, "Air Interface For Fixed and Mobile Broadband Wireless Access Systems"" IEEE 802.16E, 28 February 2006 (2006-02-28), pages 626-630, XP002515198 | 1-5 | INV. H03M13/00 |
| X | ----- | 6 | |

TECHNICAL FIELDS
SEARCHED     (IPC)

H03M

## INCOMPLETE SEARCH

The Search Division considers that the present application, or one or more of its claims, does/do
not comply with the EPC to such an extent that a meaningful search into the state of the art cannot
be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| The Hague | 16 February 2009 | Van Staveren, Martin |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................................

& : member of the same patent family, corresponding
    document

EPO FORM 1503 03.82 (P04E07)

Europäisches
Patentamt

European
Patent Office

Office européen
des brevets

**INCOMPLETE SEARCH
SHEET C**

Application Number

EP 09 10 0063

Claim(s) searched incompletely:
     1-6

Reason for the limitation of the search:

Claim 1 defines "A method of encoding for LDPC codes". However, claim 1 only defines matrix construction, without defining any steps of using the resulting matrix in encoding. Similarly, claim 2 does not define decoding steps, and claim 5 does not define data transmission steps. H matrix construction as such is known from a.o. the cited IEEE 802.16e document. The application does not define devices that would both configure an H-matrix and then use it to perform LDPC encoding or decoding. Therefore, it seems that claims 1, 2 and 5 only define matrix construction without defining any technical use of the resulting matrix. Such subject-matter is excluded from patentability under Art. 52(2) EPC: mathematical method. Claim 6 defines a system, such as a general purpose computer, which may be used for constructing a matrix. To implement a method which is itself not patentable on a general purpose computer without any further technical adaptations being necessary is not inventive. Therefore the search report only cites the relevant part of the IEEE standard.